(19) Europäisches Patentamt
European Patent Office
Office européen des brevets

(11) EP 0 892 089 A2

# (12) EUROPEAN PATENT APPLICATION

(43) Date of publication:
**20.01.1999 Bulletin 1999/03**

(51) Int. Cl.[6]: **C25D 5/54**

(21) Application number: **98113281.4**

(22) Date of filing: **16.07.1998**

(84) Designated Contracting States:
**AT BE CH CY DE DK ES FI FR GB GR IE IT LI LU MC NL PT SE**
Designated Extension States:
**AL LT LV MK RO SI**

(30) Priority: **18.07.1997 JP 209959/97**

(71) Applicant:
**Fuji Photo Film Co., Ltd.**
**Kanagawa-ken (JP)**

(72) Inventor: **Kawata, Ken**
**Minami-Ashigara-shi, Kanagawa-ken (JP)**

(74) Representative:
**Weisert, Annekäte, Dipl.-Ing. Dr.-Ing. et al**
**Patentanwälte**
**Kraus Weisert & Partner**
**Thomas-Wimmer-Ring 15**
**80539 München (DE)**

## (54) Metallized material-making method

(57) A layer (film) of a polymer derived from a specific compound having a carbon-carbon triple bond in the same molecule is first formed on a substrate made up of a non-conducting or semiconducting material. Then, the polymer layer is brought in contact with a palladium element-containing solution to impart electrical conductivity thereto, thereby obtaining an electrically conductive layer to which electroplating can be applied. Finally, a metal layer (film) is provided by electroplating on the electrically conductive layer to obtain a metallized material.

EP 0 892 089 A2

## Description

The present invention is a novel metallized material-making method, and a metallized material as well.

By the term "metallized material" used herein is intended an electrically conductive material obtained by forming a metal coat on a substrate such as a non-conducting or semiconducting material. Such a metallized material, for instance, has applications for ornamentals, plastics possessing a metallic luster and weather resistance, and electrically conductive members for electronic materials.

BACKGROUND OF THE INVENTION

JP-A 2-205686 discloses the polymerization, and electroless plating of a compound having a carbon-carbon triple bond in the same molecule.

Eelectroless plating is a plating technique making use of reduction due to the catalytic action of the surface of a material, and hence is often called chemical plating. Unlike electroplating, electroless plating has a major advantage of being able to apply plating to recesses with an uniform thickness. For this reason, electroless plating has use for making synthetic resin electrically conductive for electroplating, fabricating thin films for printed circuits, etc.

Electroless plating uses formalin as a reducing agent. However, a ban is being put on the use of formalin, partly because formalin gives off an offensive odor, and partly because some people believe that formalin is a sort of carcinogen. Furthermore, formalin is found to have an adverse influence on the environment, and cause damage to human bodies, e.g., skin inflammation. To keep copper ions in a stable alkaline state, on the other hand, EDTA is widely used as a chelating agent. However, EDTA also offers some problems because it has difficulty in waste water disposal, and it combines with heavy metals for re-dissolution.

In view of these environmental problems, formalin-free electroless copper plating solutions, etc. have been developed.

By the way, the rate of forming a metal film by electroless plating is very slow. Hence, even a relatively thin copper film of about 10 to 20 nm in thickness on flexible printed boards cannot be obtained only by use of electroless printing. Usually, electroless plating is used to make a primer layer electrically conductive for the purpose of electroplating the surface of synthetic resin, as previously noted, and so requires relatively awkward process control. From this perspective, and in view of the environment as well, some improvements are desired.

SUMMARY OF THE INVENTION

It is therefore an object of the invention to provide a metallized material-making method which can make a non-conducting material such as synthetic resin or a semi-conducting material electrically conductive in a simple manner to thereby obtain a metallized material to which electroplating can be applied directly. Another object of the invention is to use such a metallized material-making method for the production of a metallized material.

Such an object is achieved by the inventions defined below as (1) to (19).

(1) A metallized material-making method, comprising steps of:

forming on a surface of a substrate a primer layer made up of a material obtained by polymerization of a compound having a carbon-carbon triple bond in the same molecule and represented by the following general formula:

$$(R\text{-}(C{\equiv}C)_l)_k\text{-}L\text{-}A_m$$

where:

A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group,
R represents an element in group 8 or group 1B of the periodic table,
L represents a chemical bond or a (k+m)-valent bridging group,
k is an integer of 1 or more,
l is an integer of 1 or more, and
m is 0 or an integer of 1 or more,
bringing said primer layer in contact with a palladium-containing solution to thereby impart electrical conductivity to said primer layer, and

providing a metallized layer on said primer layer with electrical conductivity imparted thereto by means of electroplating.

(2) The metallized material-making method according to (1), wherein an electrical conductivity of said primer layer is regulated to 200 Ω/□ or lower by imparting electrical conductivity thereto.
(3) The metallized material-making method according to (1) or (2), wherein said compound represented by said general formula is thermally treated for polymerization at a temperature ranging from 100°C to 200°C for 0.5 minutes to 90 minutes.
(4) The metallized material-making method according to (3), wherein said compound represented by said general formula is thermally treated for polymerization in the presence of a nitrate.
(5) The metallized material-making method according to any one of (1) to (4), wherein said substituent R in said compound represented by said general formula is an element in group 1B of the periodic table.
(6) The metallized material-making method according to (5), wherein said group 1B element is silver.
(7) The metallized material-making method according to any one of (1) to (6), wherein A in said compound represented by said general formula is a polyethoxyether group.
(8) The metallized material-making method according to any one of (1) to (7), wherein a solution of said compound represented by said general formula, to which solution a surface active agent is added, is coated in a film form on said substrate, followed by polymerization of said compound.
(9) A metallized material-making method, comprising steps of:

forming on a surface of a substrate a primer layer made up of a material obtained by polymerization of a compound having a carbon-carbon triple bond in the same molecule and represented by the following general formula in the presence of an element in group 8 or group 1B of the periodic table:

$$(R\text{-}(C\equiv C)_l)_k\text{-}L\text{-}A_m$$

where:
A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group,
R represents a carboxyl group or a salt thereof, an alkyl group, a cycloalkyl group, an alkenyl group, an alkynyl group, a silyl group, an aryl group, an aralkyl group, an ester group, a heterocyclic group, and an element in group 8 or group 1B of the periodic table,
L represents a chemical bond or a (k+m)-valent bridging group,
k is an integer of 1 or more,
l is an integer of 1 or more, and
m is 0 or an integer of 1 or more,
bringing said primer layer in contact with a palladium-containing solution to thereby impart electrical conductivity to said primer layer, and
providing a metallized layer on said primer layer with electrical conductivity imparted thereto by means of electroplating.

(10) The metallized material-making method according to (9), wherein an electrical conductivity of said primer layer is regulated to 200 Ω/□ or lower by imparting electrical conductivity thereto.
(11) The metallised material-making method according to (9) or (10), wherein said compound represented by said general formula is thermally treated for polymerization at a temperature ranging from 100°C to 200°C for 0.5 minutes to 90 minutes.
(12) The metallized material-making method according to (11), wherein said compound represented by said general formula is thermally treated for polymerization in the presence of a nitrate.
(13) The metallized material-making method according to any one of (9) to (12), wherein said substituent R in said compound represented by said general formula is an element in group 1B of the periodic table.
(14) The metallized material-making method according to (13), wherein said group 1B element is silver.
(15) The metallized material-making method according to any one of (9) to (14), wherein A in said compound represented by said general formula is a polyethoxyether group.
(16) The metallized material-making method according to any one of (9) to (15), wherein a solution of said compound represented by said general formula, to which solution a surface active agent is added, is coated in a film form on said substrate, followed by polymerization of said compound.

(17) A metallized material comprising a substrate made up of a non-conducting or semiconducting material, an intermediate layer provided on a surface of said substrate and an electroplated layer provided on said intermediate layer, wherein:

said intermediate layer comprises a mixture of a compound derived from a compound having a carbon-carbon triple bond in the same molecule and represented by the following general formula, an alloy of an element in group 8 or group 1B of the periodic tale with palladium or a palladium element, and a metal material that forms an electroplated layer:

$$(R\text{-}(C{\equiv}C)_l)_k\text{-}L\text{-}A_m$$

where:
A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group,
R represents a carboxyl group or a salt thereof, an alkyl group, a cycloalkyl group, an alkenyl group, an alkynyl group, a silyl group, an aryl group, an aralkyl group, an ester group, a heterocyclic group, and an element in group 8 or group 1B of the periodic table,
L represents a chemical bond or a (k+m)-valent bridging group,
k is an integer of 1 or more,
l is an integer of 1 or more, and
m is 0 or an integer of 1 or more.

(18) The metallized material according to (17), wherein said substrate is a flexible printed board made up of a polyimide resin, polyethylene naphthalate or polyethylene terephthalate, and provided thereon with said electroplated layer that is a copper layer formed in a patterned state.
(19) The metallized material according to (17) or (18), wherein said electroplated layer has a thickness of 5 to 20

DETAILED EXPLANATION OF PREFERRED EMBODIMENTS

Preferred embodiments of the invention will now be explained at great length.

According to the invention, a layer (film) of a polymer derived from the compound having a carbon-carbon triple bond is first formed on a substrate made up of a non-conducting or semiconducting material. Then, the polymer layer is brought in contact with a palladium element-containing solution to impart electrical conductivity thereto, thereby obtaining an electrically conductive layer to which electroplating can be applied. Finally, a metal layer (film) is provided by electroplating on the electrically conductive layer to obtain a metallized material.

In the invention, the polymer derived from the compound having a carbon-carbon triple bond has a carbon-carbon triple or double bond in its main or side chain.

The aforesaid polyacetylene type polymer may be dispersed in or blended with other polymer provided that its constituting unit has basically a carbon-carbon triple or double bond. Such other polymer includes a variety of synthetic, and natural resins of the thermoplastic, heat-curable, and reactive types as represented by polyphenol resin, epoxy resin, gelatin, polyvinyl alcohol, polysulfone, diacetyl cellulose, polyvinyl acetate, polystyrene, polyurethane, silicone polymer, polyether polyol, polyimide, and polybutyral.

These synthetic or natural resins may usually account for up to about $10^3$ wt% of the polyacetylene type polymer that is a plating medium material.

The aforesaid polyacetylene type polymer may contain an additional functional group selected from the group consisting of any desired functional groups. To allow the polyacetylene type polymer to exert a much higher catalytic action at an electroplating step replying upon a general aqueous wet process, however, it is preferable to make a selection from the group consisting of a hydroxyl group, an amino group, an ether group, a polyoxyether group, a polyaminoether group, a polythioether group, a sulfino group or its salt, a sulfo group or its salt, a carboxyl group or its salt, and a phosphoric acid group or its salt, among which the polyoxyether group is most preferred.

In the invention, a compound having such a functional group may be separately incorporated in the polyacetylene type polymer and the plating medium material.

Preferably in the invention, the polyacetylene type polymer is composed only of a homopolymer or copolymer containing a conjugated carbon-carbon unsaturated bond and the aforesaid additional functional group (which may be used) in its main or side chain.

The compound (monomer) having a carbon-carbon triple bond, from which the polymer according to the invention

is derived, i.e., a compound that provides a basic structure of elements constituting the polymer is represented by the following general formula:

$$(R\text{-}(C{\equiv}C)_l)_k\text{-}L\text{-}A_m$$

In this general formula, A stands for a hydrogen atom or any functional group selected from the group consisting of a hydroxyl group, an amino group, an ether group, a mercapto group, a polyoxyether group, a polyaminoether group, a polythioether group, a sulfino group or its salt, a sulfo group or its salt, a carboxyl group or its salt, and a polymerizable group (e.g., a glycidyl, vinyl or isocyanato group), among which the polyoxyether group is preferable, and an oligoethylene oxide group is more preferable.

R stands preferably for an element in group 8 of the periodic table (e.g., nickel, ruthenium, rhodium, palladium, and platinum) or an element in group 1B of the periodic table (e.g., copper, silver, and gold with silver and copper being preferred), a hydrogen atom, a carboxyl group or its salt as well as a substituted or unsubstituted alkyl, cycloalkyl alkenyl, alkynyl, silyl, aryl, aralkyl, ester or heterocyclic group. It is here to be noted that when R is a hydrogen atom, it is required to carry out polymerization in the presence of the group 8 element (e.g., nickel, ruthenium, rhodium, palladium, and platinum) or the group 1B element (e.g., copper, silver, and gold with silver and copper being preferred), using such a method as will be described later.

L represents a chemical bond or a (k+m)-valent group via which the carbon-carbon triple bond is linked to A, for instance, an alkylene group, an arylene group, an aralkylene group, a vinylene group, a cycloalkylene group, a glutaroyl group, a phthaloyl group, hydrazo group or an ureylene group which may, or may not, be substituted, or a thio group, a carbonyl group, an oxy group, an imino group, a sulfinyl group, a sulfonyl group, a thiocarbonyl group, an oxalyl group or an azo group. These groups may be used in combination of two or more. In this regard, it is to be noted that

k is an integer of 1 or more,
l is an integer of 1 or more, and
m is 0 or an integer of 1 or more.

By way of example but not by way of limitation, set out below are preferable monomers.

(1) $HC\equiv CCH_2OCH_2CH_2OCH_2CH_2OCH_2CH_2OCH_2CH_3$

(2) 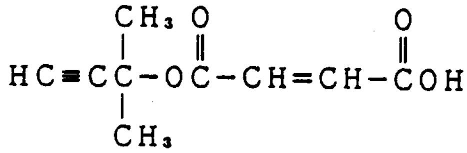

(3) 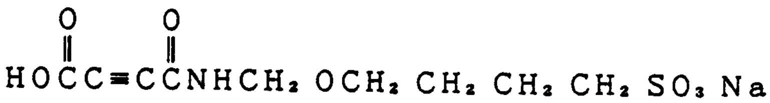

(4) 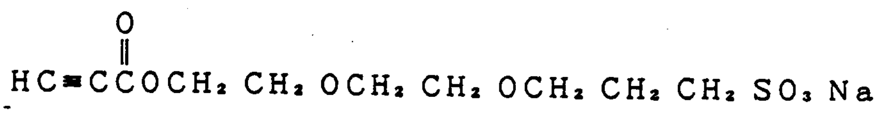

(5) 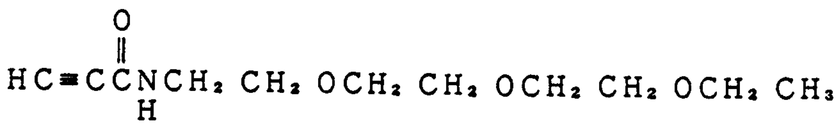

(6) 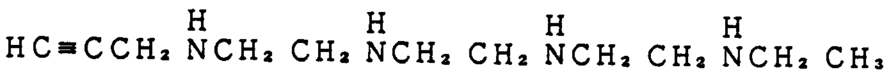

(7) $HC\equiv CCH_2SCH_2CH_2SCH_2CH_2SCH_2CH_2SCH_3$

(8) $(HC\equiv CCH_2O-CH_2)_3C$
$-CH_2OCH_2CH_2OCH_2CH_2OCH_2CH_2OCH_2$
$-CH_2O-CH_2CH_3$

(9) 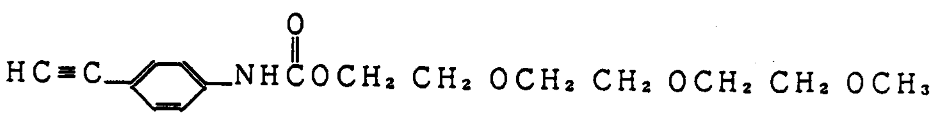

(10) $C_{11}H_{23}C\equiv C-C\equiv C-(CH_2)_8CO_2H$

(11) 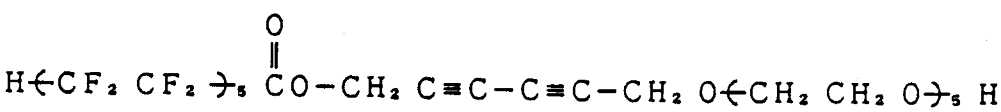

(12) $C_{20}H_{41}C\equiv C-C\equiv C-CO_2H$

(13) $HO\overset{O}{\overset{\|}{C}}C\equiv C-C\equiv C-(CH_2)_8CO_2H$

(14) $C_{11}H_{23}C\equiv C-C\equiv C-CH_2CH_2O(CH_2CH_2O)_6H$

(15) $C_{11}H_{23}C\equiv C-C\equiv C-CH_2CH_2OCH_2CH_2CH_2SO_3H$

(16) $H(CF_2)_5OCH_2-C\equiv C-C\equiv CCH_2-O\overset{O}{\overset{\|}{C}}CH_2CH_2\overset{O}{\overset{\|}{C}}OH$

(17) $CH_3(CH_2)_5C\equiv C-C\equiv C-(CH_2)_6CO_2H$

(18) $C_4H_9NH\overset{O}{\overset{\|}{C}}O(CH_2)_8C\equiv C-C\equiv C-(CH_2)_6O\overset{O}{\overset{\|}{C}}NHC_4H_9$

(19) 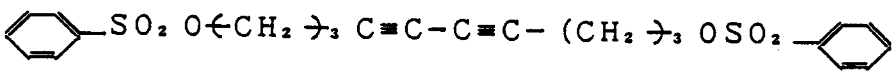

(20) $CH_2=CH\overset{O}{\overset{\|}{C}}NHCH_2OCH_2CH_2OCH_2CH_2OCH_2C\equiv CH$

(21) $CH_2=CH-\overset{O}{\overset{\|}{C}}OCH_2CH_2OCH_2CH_2OCH_2CH_2OCH_2C\equiv CH$

(22) $HC\equiv C-CH_2OCH_2CH_2OCH_2CH_2OCH_2CH_2OCH_2CH_2OCH_2C\equiv CH$

(23)

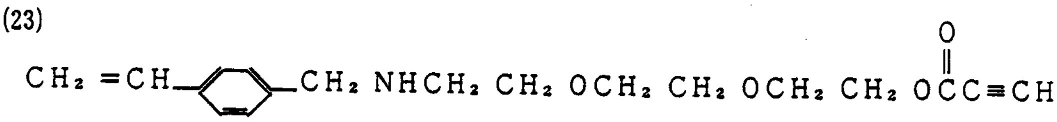

(24) 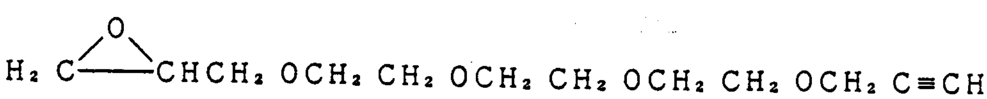

(25) $CH_3CH_2C(CH_2OCH_2C\equiv CH)_3$

(26) 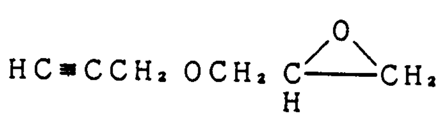

(27) $HC\equiv CCH_2OCH_2CH_2OCH_2CH_2OCH_2CH_2OH$

(28) 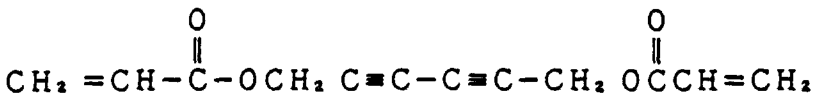

(29) 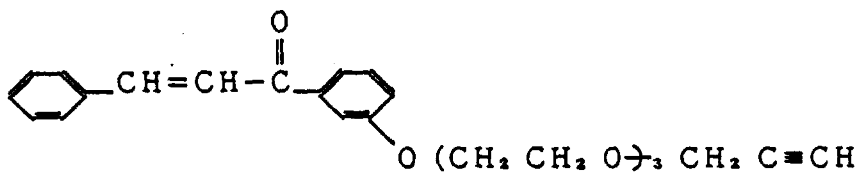

(30) 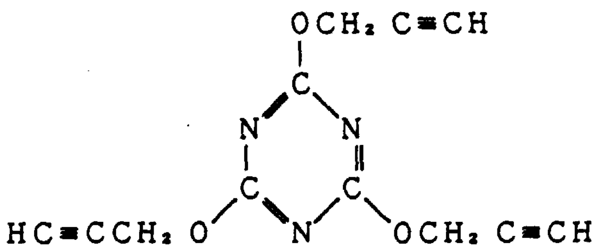

(31) 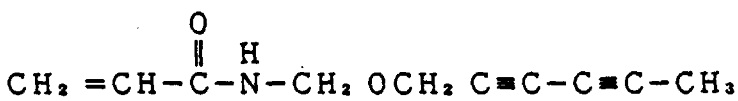

(32) $HC\equiv CCH_2OCH_2CH_2OCH_2CH_2OCH_3$

(33) $HC\equiv CCH_2OCH_3$

(34) $CH_3CH_2C\equiv CCH_2CH_2OCH_2CH_2OCH_3$

(35) 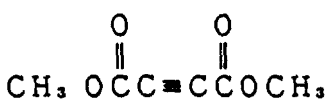

(36) 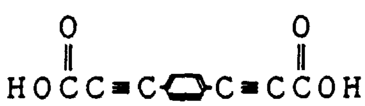

(37) $HC\equiv CCH_2OCH_2CH_2OCH_3$

(38)

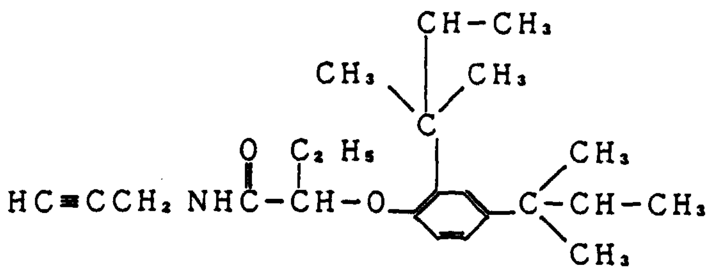

(39)

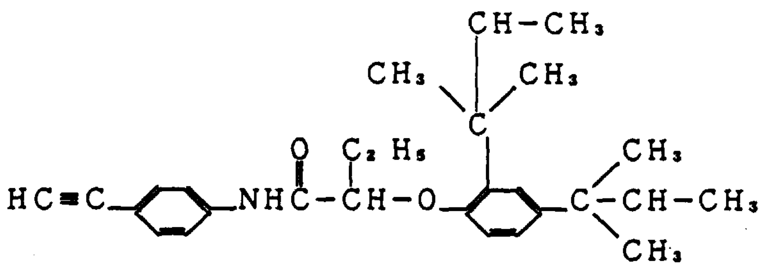

(40) $(CH_3)_3SiC{\equiv}C-CH_2OCH_2CH_2OCH_2CH_2OCH_3$

(41) $HC{\equiv}CCH_2OCH_2CH_2OCH_2CH_2OCH_2CH_2NHCH_3$

These monomers for acetylene compounds may generally be synthesized as follows.

That is, the monomers may be synthesized by condensation reactions between compounds having a carbon-carbon triple bond, e.g., propiolic acid, propargyl bromide, and propargyl alcohol and other compounds having necessary functional groups, e.g., tetraethylene glycol monoethyl ether, maleic anhydride, propanesultone, epichlorohydrin, and acrylic acid chloride.

One typical synthesis process is given below.

Synthesis of Exemplary Compound (1)

A mixture of 107 grams of triethylene glycol monoethyl ether, 107 grams of propargyl bromide and 300 grams of anhydrous potassium carbonate is heated under agitation over a water bath for 20 hours. After cooling, insolubles are filtered through Celite and the filtrate is distilled under reduced pressure. A colorless transparent liquid is obtained in an yield of 120 grams, with a boiling point of 115°C /0.6 mmHg.

Other compounds, too, may be easily synthesized as mentioned just above.

These compounds may be polymerized in a patterned state into a polyacetylene type polymer, as will be described later. For this polymerization, dimers, trimers, oligomers, etc. of these compounds may also be used.

To obtain a polyacetylene type copolymer, two or more such compounds may be used as monomers.

Monomers having a group 8 element or group 1B element as R are not exemplified herein. In the practice of the invention, however, it is possible to use the aforesaid exemplary monomers which further contain at least one of these metal elements as R.

Monomers containing these metal elements as R may be easily obtained by allowing an acetylene compound represented by $(H-(C{\equiv}C)_l)_k-L-A_m$ to react with metal salts such as silver nitrate, copper (I) chloride, platinic acid chloride, palladium chloride and auric acid chloride or their mixtures in known manners.

For such reactions, the aforesaid metal salts may be put in an aqueous solution in which the aforesaid acetylene compound is suspended. In most cases, the reactions proceed fast in the presence of ammonia or an organic amine. Then, the reaction product is generally isolated by an extraction process.

By NMR spectra or IR spectra, the thus obtained acetylene compound containing the group 8 or group 1B element is identified as a $\sigma$ or $\pi$ complex of acetylide.

At least one of such acetylene compounds or their dimers, oligomers, etc. may be polymerized into a polyacetylene

type polymer.

In the invention, for instance, nickel, ruthenium, rhodium, and palladium are mentioned for the element in group 8 of the periodic table. Copper, silver, and gold are mentioned for the element in group 1B of the periodic table, with silver and copper being most preferred.

At least one of the elements in group 8 or group 1B of the periodic table may be incorporated in the plating medium material in the form of a pure metal, a metal salt or a metal complex. In some cases, the elements are present in a form bonded or coordinated to the polyacetylene type polymer or in the form of their alloys or oxides.

Among these, preferable metal salts are silver nitrate, palladium chloride, copper (I) chloride, and platinum chloride.

Preferred metal complexes, for instance, are di-μ-chloro-bis(η-2-methylallyl)dipalladium (II) complex, tetrakis(triphenylphosphine)paladdium complex, di-μ-chlorotetracarbonyl dirhodium (I) complex, and dicyclopentadiene-gold (I) chloride.

The amount of the group 8 or group 1B element present in the polyacetylene type polymer in the form of a pure metal, a metal complex or a metal salt is preferably 5 to 500 parts by weight, and especially 10 to 500 parts by weight per 100 parts by weight of polymer.

When polymerization is carried out in the presence of such a metal element, it is preferable to use an acetylene compound containing this metal element.

The acetylene compound containing such a metal element is polymerized by thermal decomposition upon heated at a temperature of 100°C or higher, and especially 140 to 200°C for 0.5 to 90 minutes while, at the same time, the metal element is reduced into metal colloid. Preferably, this polymerization is carried out in the presence of a nitrate. For this nitrate, it is preferable to use sodium nitrate, ammonium nitrate or the like.

In the invention, the monomer, dimer, oligomer, etc. of the acetylene compound may be polymerizable in a patterned state.

Polymerization may be carried out by radiation. To polymerize the monomer, etc. in a patterned state, radiation scanning may be controlled or a pattern mask or other material may be used.

The electroplating catalyst material preferable for the practice of the invention is generally in a film form.

More specifically, a film form of catalyst material may be formed on the surface of the substrate.

The simplest method for forming the film on the substrate is to carry the monomer onto the substrate by means of coating processes.

To this end, a monomer solution or suspension may be coated on the substrate by means of curtain coating, dip coating, spray coating, spinner coating, and roll coating. No particular limitation is then imposed on the solvent used, and the concentration of the solvent.

To obtain consistent film thickness, it is preferable to use a solvent having a high solubility. Typical such solvents, for instance, are water, methanol, acetone, ketones such as methyl ethyl ketone, halogen compounds such as chloroform, and methylene chloride, esters such as ethyl acetate, amides such as dimethylacetamide, dimethylformamide, and N-methyl-2-pyrrolidone, and nitriles such as acetonitrile.

For solution coating, it is preferable to add a surface active agent to the solution. Preferably in this case, the amount of the surfactant is 0.1 to 200 parts by weight, and especially 0.3 to 100 parts by weight. The addition of the surfactant enables uniform coating, and prevents pinholes. To this end a variety of surfactants may be used; however, it is preferable to use an anionic or nonionic surfactant. A typical anionic surfactant includes sodium dodecylbenzene-sulfonate, while a typical nonionic surfactant includes N-hexadeca(ethyleneoxy)-N-propyl perfluorooctylsulfonamide.

Referring here to a specific coating process, a chloroform solution of a thermal polymerization initiator or azobisisobutyronitrile and exemplary compound (20) is spin coated on a polymethyl methacrylate substrate sheet, and then polymerized in a patterned state by use of radiation as previously mentioned. Then, an unpolymerized portion is removed with water.

Alternatively, compounds that form complexes with the metal in group 8 or group 1B of the periodic table, e.g., silver acetylides of exemplary compounds (1), (6) and 27 may be used as the polymer-forming monomers. The polymer-forming monomer is coated on a substrate sheet by means of spin coating, etc., and then polymerized in a patterned state by irradiation with ultraviolet or other radiation as previously noted. An unpolymerized portion is removed as previously noted.

Still alternatively, a solution or dispersion of a pure metal, a metal salt, an alloy or a metal compound in the monomer, for instance, may be coated on a substrate sheet, and then polymerized in a patterned state by radiation as previously noted. In this case, too, an unpolymerized portion may be removed as previously noted.

In the invention, the polymer having a carbon-carbon unsaturated bond is preferably used in an amount of 1 mg to 10 g, and especially 20 mg to 1 g per $m^2$ of substrate sheet (substrate). The thickness of the film made by this polymer optionally with other binder is preferably in the range of 0.001 μm to 5 μm, and especially 0.05 μm to 0.5 μm.

It is here to be noted that such a film may be provided with at least one of a protective layer(s) and a primer layer(s) by means of known techniques.

The Langmuir-Blodgett technique may also be applied to film formation.

The preparation of a monomolecular film by the Langmuir-Blodgett technique, and the building-up of the monomolecular film may be carried out according to ordinary procedures such as those described in "New Courses of Experimental Chemistry", Vol. 18, Interfaces and Colloids, Chapter 6, edited by the Japan Chemistry Association, published by Maruzen.

In this case, two typical methods may be used, one called a vertical dipping method wherein a substrate (substrate sheet) is moved vertically with respect to a liquid level to transfer a monomolecular film thereto, and the other called a horizontal depositing method wherein a substrate (substrate sheet) is horizontally supported to bring it in contact with a monomolecular film surface to deposit the film on the substrate.

The water to be used should be rid of organic matters by ion exchange and potassium permanganate, and then distilled. The water is used at a temperature of 15 to 20°C. If required, ions such as $Cd^{2+}$ are added to the water in an amount of $10^{-3}$ to $10^{-4}$ mol/l.

For the vertical dipping method, for instance, it is desired to use a float type Micro-plane as the device. Upon purification, the monomer is dissolved in chloroform for spectroscopic analysis, etc. at a concentration of 0.5 to 1.0 mg/ml. Upon formation, the monomolecular film is built up on a substrate sheet while the surface pressure is kept at 20 to 25 dyn/cm.

One typical application of the Langmuir-Blodgett technique is disclosed in JP-A 61-137781. First, the Langmuir-Blodgett technique is used to provide an amphiphilic monomer, e.g., exemplary compound (10), (12), (14), and (16) on a glass substrate sheet in the form of a built-up film. Then, the film is polymerized by pattern irradiation with radiation such as ultraviolet light from a high pressure mercury vapor lamp or the like, as previously explained, followed by removal of an unpolymerized portion. Finally, the polymer is dipped in a bath containing a salt of a metal in group 8 or group 1B of the periodic table.

In the practice of the invention, it is to be noted that some monomers may be polymerized by vapor-phase growth techniques generally broken down into PVD and CVD.

If, in this case, PVD, and CVD are carried out using a pattern mask material, then direct patterning can be achieved. CVD can yield a patterned polymer film.

It is to be noted that if CVD or the like is carried out by pattern-wise light irradiation, it is then possible to achieve patterning without recourse to any pattern mask material.

In the aforesaid embodiment of the invention, the polymer film is formed in a patterned state. As a matter of course, however, it is also possible to provide a polymer film covering all over the surface of the substrate.

For the substrate to be provided with the polymer film according to the invention, it is possible to make use of non-conducting or semiconducting materials, for instance, glass, quartz, ceramics, carbon, polyethylene, polyphenol, polypropylene, ABS polymer, epoxy resin, glass fiber-reinforced epoxy resin, and polyester. Use may also be made of a woven sheet (and fabric) of polyamide, polyacrylonitrile, poly(vinyl halide), cotton, and wool or a mixture thereof, or copolymers of the aforesaid monomers, threads, fibers, a fiber assembly like paper, and a particulate material such as silica. It is here to be understood that by the term "substrate" used herein are also intended metals having such a non-conducting or semiconducting material layer or film formed on their surfaces.

The thus formed intermediate layer (primer layer) is brought into contact with a palladium-containing solution. For the palladium-containing solution, an aqueous solution of palladium chloride in dilute hydrochloric acid is preferably used, with the concentration of palladium chloride being preferably at least 10 ppm, and especially 200 to 1,000 ppm. The aforesaid contact may take place as by dipping the substrate having the aforesaid intermediate layer in a bath composed of the palladium-containing solution. This dipping is preferably carried out for about 10 seconds to about 2 minutes.

Upon the substrate dipped in the aforesaid bath, palladium forms an alloy preferably with the element in group 8 or group 1B of the periodic table, so that electrical conductivity is imparted to the aforesaid intermediate layer. At this time, it is preferred that the conductivity of the intermediate layer is in the range of 10 to 1,000 Ω/□, and especially 200 Ω/□ or lower. It is here to be noted that the thus formed alloy is in an amorphous state.

According to the aforesaid method, the substrate made up of a non-conducting or semiconducting material can be easily provided thereon with a submicron thin film without using any organic solvent at all, said film providing an electrically conductive plating medium in which fine metal (alloy) particles are homogeneously dispersed throughout the polymer having a conjugated unsaturated bond.

The substrate with a plating medium material layer or film provided thereon is then electroplated for metallization, thereby obtaining a metallized material having a metal material formed in a patterned state.

Preferred for the plating bath used herein is a bath containing a nickel salt, a cobalt salt, a copper salt, a gold salt, and a silver salt, which may be used alone or in combination of two or more, optionally with an iron salt. Such a plating bath may additionally contain an inert substrate material, which may in turn be co-precipitated in the coating to be plated.

In the electroplating technique used herein, an external current is passed through a plating bath to electrochemically precipitate a metal by reduction from an aqueous solution of a salt of the metal onto the surface of a workpiece

(cathode). It is thus possible to plate a wide range of metals from heavy metals such as zinc, cadmium, tin, nickel, cobalt, iron, copper, and chromium to noble metals such as silver, gold, and rhodium. These metals may be used in a single- or multi-layer form while taking advantage of their own properties depending on what purpose they are used for.

For practical electroplating conditions, for instance, see "Guidebook to Plating Techniques", edited by Tokyo Technical Tie-Up Association for Plating Materials, 1985, and similar books.

The metallized material obtained by the metallized material-making method of the invention comprises a substrate made up of a non-conducting or semiconducting material, an intermediate (primer) layer provided on the surface of the substrate, and an electroplated layer provided on the intermediate layer. In the invention, the intermediate layer comprises a mixture of a compound derived, from the compound having a carbon-carbon triple bond in the same molecule and represented by the aforesaid general formula, an alloy of the group 8 or group 1B element with palladium or a palladium element, and a metal material that forms the electroplated layer. In the metallized material of the invention, the intermediate layer cannot perfectly be separated from the electroplated layer. In other words, at a portion of the intermediate layer contiguous to the substrate there is a relatively large amount of the compound derived from the compound having a carbon-carbon triple bond and represented by the aforesaid general formula, the alloy of the group 8 or group 1B element with palladium or the palladium element. This amount decreases from the substrate side to the electroplated layer side, and finally reaches zero at the interface between the intermediate layer and the electroplated layer. Such a layer structure may be identified by the ESCA measurement of the intermediate, and electroplated layers upon released from the substrate.

The electroplated layer has preferably a thickness of 5 to 20 μm. This thickness can be practically unachievable by use of electroless plating.

The width of fine lines forming the metal material pattern obtained by the invention is of the order of 1 to 100 μm, and preferably about 1 μm. Hence, the metallized material of the invention is suitable for high-density and high-precision printed wiring boards. Preferably in this case, the substrate (substrate sheet) is made up of polyimide resin, polyethylene naphthalate, and polyethylene terephthalate. The present invention is most preferred for flexible wiring boards. In such a wiring board in particular, it is preferable to use copper for the metal material pattern.

EXAMPLE

To explain the invention in more detail, some examples are given below.

Example 1

A silver salt of exemplary compound (1) was prepared as follows.

While light was cut off, 16.4 grams of sodium acetate and 16.7 grams of silver acetate were suspended in 200 ml of distilled water at 40°C. Exemplary compound (1) (20.1 grams) was added dropwise to the suspension, which was stirred for 20 minutes, and then cooled down to room temperature. The suspension was neutralized with 7.8 grams of sodium hydrogen-carbonate, and the supernatant liquid was removed by decantation therefrom. The solution was extracted by the addition of a further 200 ml of distilled water and 400 ml of chloroform thereto. After dried over anhydrous sodium sulfate, the chloroform phase was distilled under reduced pressure for removal of chloroform to obtain 29 grams of a white solid wax in a substantially quantitative yield.

From NMR spectra and IR spectra, it was found that this substance is a σ complex of silver.

NMR

σ 1.15 (triplet, 3H)
3.0 to 40 (multiplet, 14H)
3.4 (broad singlet, 2H)

IR 2860 $cm^{-1}$ (C-H stretch)
1980 $cm^{-1}$ (C=C stretch)
1100 $cm^{-1}$ (C-O stretch)

The silver salt (0.24 grams) of exemplary compound (1) was mixed with, and dissolved in, distilled water (0.36 grams) and methanol (1.80 grams) to prepare a solution having a concentration of 10% by weight.

The solution was coated by spin coating on a polyethylene naphthalate substrate sheet, which was then heated in an oven at 200°C for 3 minutes.

In this way, a light-brown transparent thin film insoluble in water was prepared. This thin film had a thickness of 0.1 μm, with uniform silver particles of 50 to 100 Å dispersed therein.

The thin film was dipped in a dilute hydrochloric acid solution containing 500 ppm of $PdCl_2$ for 30 seconds. The thin

film had a surface resistance of 200 Ω/□, and the results of XRD (X-ray diffraction) showed Ag and Pd peak shifts, indicating that an AgPd alloy is formed. The amounts of Ag and Pd were estimated to be 60 $mg/m^2$ and 24 $mg/m^2$, respectively.

The aforesaid polyethylene naphthalate substrate sheet was fixed onto a glass sheet to construct a cathode. While the cathode was spaced 8 cm away form an anode built up of a phosphorus-containing sheet, electrolytic copper plating was carried out.

Initially, 8 V was applied across a copper plating bath containing 200 g/l of copper sulfate, 70 g/l of sulfuric acid and 50 mg/l of chlorine ions. Five minutes later, the voltage dropped to 2 V at which a steady-state was reached at a current density of 1.8 $A/dm^2$. Fifteen minutes later, the obtained polyethylene naphthalate substrate sheet had a copper gloss. The copper film on the polyethylene naphthalate substrate sheet had a thickness of 10 μm.

Example 2

Experimentation was carried out as in Example 1 with the exception that exemplary compound (24) was used in a silver complex form. Similar results as in Example 1 were obtained. When $PdCl_2$ was mixed with a Pd complex of exemplary compound (27) or exemplary compound (5) upon polymerization, too, similar results were obtained.

Example 3

A silver complex of exemplary compound (1), with or without 50 mol% of ammonium nitrate, was prepared as in Example 1. The silver complex with the ammonium nitrate added thereto, and the silver complex with no ammonium nitrate added thereto were treated as in Example 1 with the exception of an oven heating at 150°C. After coming in contact with palladium, the former showed a surface resistance of 110 Ω/□, and the latter a surface resistance of 300 to 700 KΩ/□. Under the electroplating conditions in Example 1, the former was much higher in activity than the latter.

According to the invention, the end coating film can be formed in simple operation such as coating, and heating with no need of special pre-treatments. Subsequent contact of the film with an aqueous solution of palladium can yield a plating medium film containing a metal having a conductivity as high as the progress of electroplating is easily achievable. It is thus possible to obtain a metallized material in an easier manner than ever before.

This can dispense with an electroless plating technique on the use of which some ban will be put from a perspective of preservation of the environment, and severe electroplating conditions which have been employed so far in the art. Hence, the metallized material of the invention is expected to have high reliability.

**Claims**

1. A metallized material-making method, comprising steps of:

    forming on a surface of a substrate a primer layer made up of a material obtained by polymerization of a compound haying a carbon-carbon triple bond in the same molecule and represented by the following general formula:

    $$(R\text{-}(C\equiv C)_l)_k\text{-}L\text{-}A_m$$

    where:
    A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group,
    R represents an element in group 8 or group 1B of the periodic table,
    L represents a chemical bond or a (k+m)-valent bridging group,
    k is an integer of 1 or more,
    l is an integer of 1 or more, and
    m is 0 or an integer of 1 or more,
    bringing said primer layer in contact with a palladium-containing solution to thereby impart electrical conductivity to said primer layer, and
    providing a metallized layer on said primer layer with electrical conductivity imparted thereto by means of electroplating.

2. The metallized material-making method according to claim 1, wherein an electrical conductivity of said primer layer

is regulated to 200 Ω/□ or lower by imparting electrical conductivity thereto.

3. The metallized material-making method according to claim 1, wherein said compound represented by said general formula is thermally treated for polymerization at a temperature ranging from 100°C to 200°C for 0.5 minutes to 90 minutes.

4. The metallized material-making method according to claim 3, wherein said compound represented by said general formula is thermally treated for polymerization in the presence of a nitrate.

5. The metallized material-making method according to claim 1, wherein said substituent R in said compound represented by said general formula is an element in group 1B of the periodic table.

6. The metallized material-making method according to claim 5, wherein said group 1B element is silver.

7. The metallized material-making method according to claim 1, wherein A in said compound represented by said general formula is a polyethoxyether group.

8. The metallized material-making method according to claim 1, wherein a solution of said compound represented by said general formula, to which solution a surface active agent is added, is coated in a film form on said substrate, followed by polymerization of said compound.

9. A metallized material-making method, comprising steps of:

forming on a surface of a substrate a primer layer made up of a material obtained by polymerization of a compound having a carbon-carbon triple bond in the same molecule and represented by the following general formula in the presence of an element in group 8 or group 1B of the periodic table:

$$(R\text{-}(C{\equiv}C)_l)_k\text{-}L\text{-}A_m$$

A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group, R represents a carboxyl group or a salt thereof, an alkyl group, a cycloalkyl group, an alkenyl group, an alkynyl group, a silyl group, an aryl group, an aralkyl group, an ester group, a heterocyclic group, and a metal element in group 8 or group 1B of the periodic table,
L represents a chemical bond or a (k+m)-valent bridging group,
k is an integer of 1 or more,
l is an integer of 1 or more, and
m is 0 or an integer of 1 or more,
bringing said primer layer in contact with a palladium-containing solution to thereby impart electrical conductivity to said primer layer, and
providing a metallised layer on said primer layer with electrical conductivity imparted thereto by means of electroplating.

10. The metallized material-making method according to claim 9, wherein an electrical canductivity of said primer layer is regulated to 200 Ω/□ or lower by imparting electrical conductivity thereto.

11. The metallized material-making method according to claim 9, wherein said compound represented by said general formula is thermally treated for polymerization at a temperature ranging from 100°C to 200°C for 0.5 minutes to 90 minutes.

12. The metallized material-making method according to claim 11, wherein said compound represented by said general formula is thermally treated for polymerization in the presence of a nitrate.

13. The metallized material-making method according to claim 9, wherein said substituent R in said compound represented by said general formula is an element in group 1B of the periodic table.

14. The metallized material-making method according to claim 13, wherein said group 1B element is silver.

15. The metallized material-making method according to claim 9, wherein A in said compound represented by said general formula is a polyethoxyether group.

16. The metallized material-making method according to claim 9, wherein a solution of said compound represented by said general formula, to which solution a surface active agent is added, is coated in a film form on said substrate, followed by polymerization of said compound.

17. A metallized material comprising a substrate made up of a non-conducting or semiconducting material, an intermediate layer provided on a surface of said substrate and an electroplated layer provided on said intermediate layer, wherein:

said intermediate layer comprises a mixture of a compound derived from a compound having a carbon-carbon triple bond in the same molecule and represented by the following general formula, an alloy of an element in group 8 or group 1B of the periodic table with palladium or a palladium element, and a metal material that forms an electroplated layer:

$$(R\text{-}(C{\equiv}C)_l)_k\text{-}L\text{-}A_m$$

where:
A represents a hydrogen atom or a functional group selected from a group consisting of a hydroxyl group, an amino group, an ether group, a mercapto group, a polyoxyether group, a polyaminoether group, a polythioether group, a sulfino group or a salt thereof, a sulfo group or a salt thereof, a carboxyl group or a salt thereof, and a phosphoric acid group or a salt thereof, and a polymerizable group,
R represents a carboxyl group or a salt thereof, an alkyl group, a cycloalkyl group, an alkenyl group, an alkynyl group, a silyl group, an aryl group, an aralkyl group, an ester group, a heterocyclic group, and a metal element in group 8 or group 1B of the periodic table,
L represents a chemical bond or a (k+m)-valent bridging group,
k is an integer of 1 or more,
l is an integer of 1 or more, and
m in 0 or an integer of 1 or more.

18. The metallized material according to claim 17, wherein said substrate is a flexible printed bard made up of a polyimide resin, polyethylene naphthalate or polyethylene terephthalate, and provided thereon with said electroplated layer that is a copper layer formed in a patterned state.

19. The metallized material according to claim 17, wherein said electroplated layer has a thickness of 5 to 20 μm.